(19) Europäisches Patentamt / European Patent Office / Office européen des brevets

(11) **EP 2 023 613 A1**

## (12) EUROPEAN PATENT APPLICATION
published in accordance with Art. 153(4) EPC

(43) Date of publication:
**11.02.2009 Bulletin 2009/07**

(21) Application number: **07742925.6**

(22) Date of filing: **08.05.2007**

(51) Int Cl.:
*H04N 5/335* (2006.01)    *H01L 27/146* (2006.01)

(86) International application number:
**PCT/JP2007/059490**

(87) International publication number:
**WO 2007/132695 (22.11.2007 Gazette 2007/47)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **11.05.2006 JP 2006132957**

(71) Applicant: **Hirotsu, Fusayoshi
Shingumachi,
Kasuya-gun,
Fukuoka 811-0103 (JP)**

(72) Inventors:
• **HIROTSU, Fusayoshi
Kasuya-gun, Fukuoka 8110103 (JP)**
• **HIROTSU, Junichi
Kasuya-gun, Fukuoka 811-0103 (JP)**

(74) Representative: **Brown, Kenneth Richard
R.G.C. Jenkins & Co.
26 Caxton Street
London SW1H 0RJ (GB)**

(54) **SEMICONDUCTOR IMAGING ELEMENT**

(57) A signal charge corresponding to an incident light quantity is accumulated in a first node (N1) of each pixel circuit (10). An accumulated charge exhaust circuit (20) includes each of first nodes (N1) of the plurality of pixel circuits (10) belonging to the same pixel group, and a second node (N2) connected through discharge gates (DG) functioning as variable resistance elements. Second node (N2) functions as a floating drain during an ON period of a control switch (24), while accumulating the signal charge overflowing from each pixel circuit (10), in a capacitor (22) during an OFF period of control switch (24) provided at an intermediate timing in one frame period. When the incident light to the pixel group is intense, a resistance value of each discharge gate (DG) is lowered in response to an increase of the signal charge accumulated in capacitor (22), so that the signal charge accumulated in each pixel circuit can be exhausted once at the above intermediate timing.

FIG. 1

EP 2 023 613 A1

**Description**

TECHNICAL FIELD

The present invention relates to a semiconductor image sensing device and more particularly, to a semiconductor image sensing device capable of taking an image in a large dynamic range and detecting a sufficient contrast in an entire region even when there is a large difference in luminance in a visual field.

BACKGROUND ART

A solid-state image sensor such as a CCD (Charge-coupled device) and CMOS (Complementary metal-oxide semiconductor) imager, that is, a semiconductor image sensor (referred to as the "semiconductor image sensing device" also hereinafter) comes to be built in a mobile phone as well as in a video camera and a digital camera, and it is widely used as an inexpensive and low-power-consumption image sensing device.

However, a sensing ability of the semiconductor image sensing device is considerably inferior to that of a human being. A contrast between a bright part and a dark part can be sufficiently detected by a human visual sense even when there is a four to five-digit luminance distribution in one visual field. This excellent contrast sensing ability is implemented by a function in which a light receiving cell in the retina can adjust its light sensing characteristics with respect to each cell.

Meanwhile, according to a conventional semiconductor image sensing device, since all pixels have the same light receiving characteristics, it is difficult to detect a sufficient contrast between a bright part and a dark part in the visual field at the same time. Thus, for example, each of Japanese Patent Laying-Open No. 2000-340779 (referred to as the patent document 1 hereinafter) and Japanese Patent Laying-Open No. 2005-160031 (referred to as the patent document 2 hereinafter) discloses a configuration of a semiconductor image sensing device provided with a mechanism in which a light receiving sensitive range in each pixel circuit can be shifted based on an incident light quantity to a peripheral pixel, in order to implement a wide light receiving sensitive range and a high contrast detecting function.

Patent document 1: Japanese Patent Laying-Open No. 2000-340779

Patent document 2: Japanese Patent Laying-Open No. 2005-160031

DISCLOSURE OF THE INVENTION

PROBLEMS TO BE SOLVED BY THE INVENTION

However, according to the configuration disclosed in the patent document 1, each pixel circuit needs to have two photodetection elements such as a first photodetection element for detecting a light receiving quantity of itself, and a second photodetection element connected to another pixel circuit with each other through a resistor element to detect an average light quantity received in a peripheral pixel. Thus, it may have difficulty in implementing pixel size reduction which is indispensable to meet a request for implementing high resolution in recent years.

In addition, since the first and second photodetection elements are connected in series in each pixel circuit, a noise flowing in a node electrically connected to the peripheral pixel circuit could be superimposed on a photocurrent of the first photodetection element, and consequently, the noise is likely to be picked up and detection precision could be lowered.

In addition, according to the configuration disclosed in the patent document 2, although only one photodetection element is provided in each pixel circuit, it is necessary to use several kinds of signal currents in one pixel circuit, the configuration of the peripheral circuit therefor becomes complicated. When the peripheral circuit becomes complicated, high precision could be required for production of each component (especially a transistor) in the pixel circuit to suppress characteristic variation among pixels.

The present invention was made to solve the above problems and an object of the present invention is to provide a high-precision and miniaturized semiconductor image sensing device capable of sufficiently detecting a contrast between a bright part and a dark part even when there is a large luminance distribution in one visual field.

MEANS FOR SOLVING THE PROBLEMS

A semiconductor image sensing device according to the present invention includes a plurality of pixel circuits divided into a plurality of pixel groups, an accumulated charge exhaust circuit provided corresponding to each pixel group, and a readout circuit. Each of the pixel groups has a plurality of pixel circuits. Each of the pixel circuits has a first photodetection element, a first node having predetermined capacitance, and a first initialization circuit. The first photodetection element generates a signal charge corresponding to an incident light quantity to the pixel circuit. The first node is configured to accumulate the signal charge generated by the first photodetection element. The first initialization circuit clears the signal charge accumulated in the first node in response to switching of a frame period. The accumulated charge exhaust circuit is configured to execute a signal charge exhaust operation for exhausting the signal charge from the first node, based on an incident light quantity to the corresponding pixel group, during a charge exhaust period previously set at a predetermined timing during each frame period. Thus, the signal charge exhaust operation is executed such that a signal charge quantity exhausted from the first node per unit time is relatively increased as the incident light quantity to the corresponding pixel group is increased. The readout circuit is configured to output an electric signal corresponding to the signal charge quantity accumulated in the first node, at an output timing set at a predetermined timing after the charge exhaust period during each of the frame periods, from each of the pixel circuits.

In addition, the accumulated charge exhaust circuit does not execute the signal charge exhaust operation during the charge exhaust period when the incident light quantity into the corresponding pixel groups is small.

According to the above semiconductor image sensing device, the accumulated charge exhaust circuit provided corresponding to each pixel group can exhaust once the signal charge accumulated in each pixel circuit corresponding to the incident light quantity until then at the middle timing (predetermined timing) during the one frame period when the incident light to the corresponding pixel group is intense (high illumination). Therefore, at the time of the high illumination, a dynamic range may be enlarged based on a ratio of one frame period to a re-accumulation period from the predetermined timing to the output timing during the one frame period, at the time of imaging. Meanwhile, when the incident light to the pixel group is moderate (low illumination), the accumulated charge exhaust circuit does not execute the signal charge exhaust operation and the contrast may be ensured without enlarging the dynamic range at the time of imaging.

Thus, the contrast between the bright part and the dark part can be sufficiently detected even when the luminance distribution in the visual field is large, by enlarging the dynamic range at the time of high illumination, with the simple circuit configuration in which the one photodetection element is provided in each pixel circuit and the light quantity is detected only based on the accumulation quantity of the signal charge generated by the light receiving element.

Preferably, the accumulated charge exhaust circuit includes a second node, a control potential generation unit, a potential node, a control switch element, and a discharge gate. The second node has predetermined capacitance configured to accumulate the signal charges exhausted from the first node in each of the plurality of pixel circuits included in the pixel group when the signal charge is saturated in the first node. The control potential generation unit generates a control potential varying depending on a potential of the second node. The potential node supplies a predetermined potential to suck the signal charge. The control switch element is provided between the potential node and the second node and turned off during the charge exhaust period while turned on outside the charge exhaust period. The discharge gate is connected between the first node and the second node in the pixel group, and controls a quantity of an exhaust current of the signal charge overflowing from the first node to the second node based on the control potential. Furthermore, the discharge gate is configured to increase the exhaust current as the control potential varies when a potential of the second node varies based on an accumulated quantity of the signal charge in the second node during the charge exhaust period.

According to the above configuration, it can be determined whether or not the signal charge exhaust operation is to be performed by the accumulated charge exhaust circuit by determining the intensity of the incident light to the pixel group, based on the accumulated quantity of the signal charge overflowing from the photodetection element in the pixel circuit in the same pixel group due to the saturation of the signal charge. In addition, during the period other than the predetermined period for the operation of the accumulated charge exhaust circuit, a mechanism of the accumulated charge exhaust circuit can be implemented by use of capacitance formed in the second node serving as the overflow drain when coupled to a predetermined potential. More specifically, the configuration of the present invention can be implemented while the number of circuit elements to be arranged additionally is reduced by use of the overflow drain capacitance.

Alternatively, preferably, the accumulated charge exhaust circuit includes a second photodetection element, a second node, a control potential generation unit, a potential node, a control switch element, and a discharge gate. The second photodetection element generates a signal charge corresponding to an incident light quantity to the accumulated charge exhaust circuit. The second node has predetermined capacitance configured to accumulate the signal charges exhausted from the first node in each of the plurality of pixel circuits included in the pixel group when the signal charge is saturated in the first node, and the signal charge generated from the second photodetection element. The control potential generation unit generates a control potential varying depending on a potential of the second node. The potential node supplies a predetermined potential to suck the signal charge. The control switch element is provided between the potential node and the second node, and turned off during the charge exhaust period while turned on outside the charge exhaust period. The discharge gate is connected between the first node and the second node in the pixel group, and controls a quantity of an exhaust current of the signal charge overflowing from the first node to the second node based on the control potential. Furthermore, the discharge gate is configured to increase the exhaust current as the control potential varies when the potential of the second node varies based on an accumulated quantity of the signal charge in the second node during the charge exhaust period.

According to the above configuration, both of the signal charge generated by the single photodetection element (second photodetection element) shared by the plurality of pixel circuits in the same pixel group, and the saturated signal charge in the photodetection element (first photodetection element) in each pixel circuit in the pixel group can detect that the incident light quantity of the pixel group is large, so that the operation for discharging the signal charge can be executed by the accumulated charge exhaust circuit in response to that detection. Thus, since the one frame period required for obtaining the same dynamic range at the time of high illumination can be relatively shortened, the imaging operation can be executed at higher speed. In addition, a mechanism of the accumulated charge exhaust circuit can be implemented while the number of circuit elements to be arranged additionally is reduced by use of the overflow drain capacitance.

Alternatively, preferably, the accumulated charge exhaust circuit includes a second photodetection element, a second node, a control potential generation unit, a potential node, a control switch element, and a discharge gate. The second photodetection element generates a signal charge corresponding to an incident light quantity to the accumulated charge exhaust circuit. The second node has predetermined capacitance configured to accumulate the signal charge generated from the second photodetection element. The control potential generation unit generates a control potential varying depending on a potential of the second node. The potential node supplies a predetermined potential to suck the signal charge. The control switch element is provided between the potential node and the second node, and turned off during the charge exhaust period while turned on outside the charge exhaust period. The discharge gate is connected between the first node and the second node in the pixel group, and controls a quantity of an exhaust current of the signal charge overflowing from the first node to the second node based on the control potential. Furthermore, the discharge gate increases the exhaust current as the control potential varies when a potential of the second node varies based on an accumulated quantity of the signal charge in the second node during the charge exhaust period.

According to the above configuration, the incident light quantity to the pixel group is detected by the single photodetection element (second photodetection element) shared by the plurality of pixel circuits in the same pixel group, and it can be determined whether the signal charge exhaust operation is to be executed by the accumulated charge exhaust circuit or not based on the detection result. In addition, a mechanism of the accumulated charge exhaust circuit can be implemented such that the overflow drain capacitance is used and the number of circuit elements required to be arranged additionally can be reduced.

Further preferably, the discharge gate is a variable resistance element varying its resistance value based on the control potential from the control potential generation unit. Thus, the variable resistance element is configured such that the resistance value is decreased as the control potential varies in response to an increase of an accumulated quantity of the signal charge in the second node.

In addition, further preferably, the discharge gate includes a first field effect transistor having a first impurity diffusion region constituting the first node as a source and a second impurity diffusion region constituting the second node as a drain. The control potential generation unit generates the control potential and outputs the control potential to the first field effect transistor so that a channel resistance between the source and the drain is decreased as an accumulated quantity of the signal charge in the second node is increased. Each pixel circuit further includes a second field effect transistor and a second initialization circuit. The second field effect transistor is configured to transfer the signal charge accumulated in the first impurity diffusion region to a third impurity diffusion region when the second field effect transistor is turned on in a saturated region or a linear region at the output timing. The second initialization circuit clears the signal charge in the third impurity diffusion region prior to turn-on of the second field effect transistor during the same frame period. Thus, the readout circuit is configured to output the electric signal corresponding to a quantity of the signal charge accumulated in the third impurity diffusion region at the output timing.

According to the above configuration, the signal charge accumulated in the first impurity diffusion region corresponding to the first node can be transmitted to the accumulated charge exhaust circuit or the readout circuit by the first and second field effect transistors formed between the second impurity diffusion region and the third impurity diffusion region. Thus, since the signal charge can be taken out without providing a contact point directly contacting with the first node physically, the first photodetection element can be made of the buried diode, so that the structure can have high noise resistance.

Alternatively, preferably, the accumulated charge exhaust circuit is formed in a region surrounded by the plurality of pixel circuits included in the corresponding pixel group, in a plane for receiving the incident light in the above semiconductor image sensing device.

According to the above configuration, since the accumulated charge exhaust circuit can be efficiently arranged, the semiconductor image sensing device can be miniaturized.

EFFECTS OF THE INVENTION

According to the present invention, even when the luminance distribution in one visual field is large, the contrast between the bright part and the dark part can be detected sufficiently, so that the high-precision and miniaturized semiconductor image sensing device can be implemented with the simple circuit configuration.

BRIEF DESCRIPTION OF THE DRAWINGS

Fig. 1 is a circuit diagram for describing a schematic configuration of a main part of a semiconductor image sensing device according to a first embodiment of the present invention.

Fig. 2 is a plan view showing an arrangement example of pixel circuits and an accumulated charge exhaust circuit shown in Fig. 1.

Fig. 3 is a sectional view taken along a line III-III in Fig. 2.

Fig. 4 is a circuit diagram showing a configuration example of an inverting amplifier shown in Fig. 1.

Fig. 5 is a conceptual diagram for describing a blooming phenomenon when an incident light to a photodiode is intense.

Fig. 6 is a conceptual diagram for describing an operation of an overflow drain.

Fig. 7 is a timing chart for describing an operation of the semiconductor image sensing device according to the first embodiment for a one frame period.

Fig. 8 is a conceptual diagram for describing formation of a potential barrier and movement of a signal charge at each point of the timing chart shown in Fig. 7.

Fig. 9 is a block diagram showing an entire configuration of the semiconductor image sensing device according to the first embodiment.

Fig. 10 is a circuit diagram for describing a schematic configuration of a main part of a semiconductor image sensing device according to a variation of the first embodiment of the present invention.

Fig. 11 is a timing chart for describing an operation of the semiconductor image sensing device according to the variation of the first embodiment for one frame period.

Fig. 12 is a circuit diagram for describing a schematic configuration of a main part of a semiconductor image sensing device according to a second embodiment of the present invention.

Fig. 13 is a sectional view showing a specific structure example of an accumulated charge exhaust circuit shown in Fig. 12.

Fig. 14 is a circuit diagram showing a first configuration example of a pixel circuit according to a third embodiment.

Fig. 15 is a circuit diagram showing a second configuration example of the pixel circuit according to the third embodiment.

Fig. 16 is a circuit diagram showing a first configuration example of an accumulated charge exhaust circuit according to the third embodiment.

Fig. 17 is a circuit diagram showing a second configuration example of the accumulated charge exhaust circuit according to the third embodiment.

DESCRIPTION OF THE REFERENCE SIGNS

2 pixel group, 3 region (pixel group), 5 power supply node, 6 ground node, 10, 10#, 11, 11# each pixel circuit, 12 transfer gate, 14 reset switch, 16 voltage amplifier, 18 pixel selection switch, 20, 20#, 21, 21# accumulated charge exhaust circuit, 22 overflow drain capacitor, 24 control switch, 26 inverting amplifier, 27, 28 n-MOS transistor, 30 arrangement region (photodiode), 32, 35 boundary region, 34 arrangement region (overflow drain), 36 arrangement region (peripheral circuit), 60, 65 potential well, 70 signal charge, 100 p type silicon substrate, 110, 120 n+ diffusion region, 115 light shielding plate, 120 n diffusion region, 130 n- diffusion region, 140, 150 insulation layer, 145, 155 gate electrode, 160, 170 n-MOS transistor (field effect transistor), 200 semiconductor image sensing device, 210 control signal generation circuit, 220 voltage latch circuit, 230 signal line, 240 data line, 260 inverting amplifier, DG discharge gate, N1, N2, N3, Nf node, No output node, OFD lateral overflow drain, PD photodiode, PS pixel selection control signal, RF reset control signal, RO control signal, RS pixel selection control signal, SUB substrate region, Tag re-accumulation period, Tdr charge exhaust period, Tfr one frame period, TG transfer control signal, Vdat data column signal, VDD power supply potential, Vout output voltage signal, VSS ground potential, W1 overflow drain capacitor, W2 region under charge exhaust gate, W3 photodiode region, W4 region under transfer gate, W5 floating diffusion region.

BEST MODES FOR CARRYING OUT THE INVENTION

Embodiments of the present invention will be described in detail with reference to the drawings hereinafter. In addition, the same references are allotted to the same or corresponding parts in the drawings and their descriptions will not be repeated in principle.

(First Embodiment)

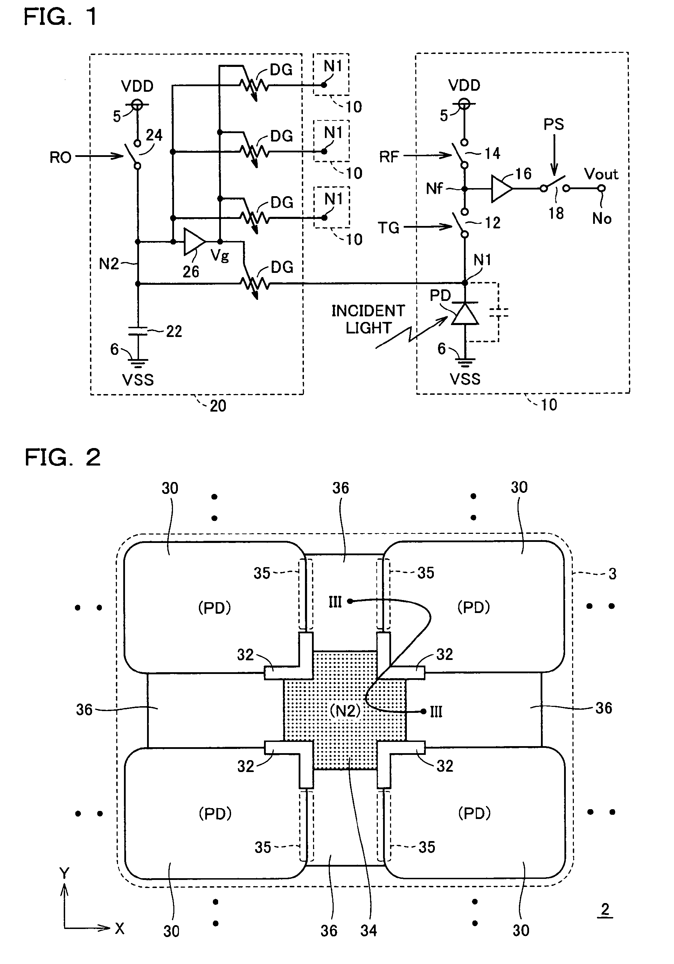

Fig. 1 is a circuit diagram for describing a schematic configuration of a main part of a semiconductor image sensing device according to a first embodiment of the present invention.

With reference to Fig. 1, a pixel circuit 10 has a photodiode PD as a light receiving detector element, a transfer gate 12, a reset switch 14, a voltage amplifier 16, and a pixel selection switch 18.

Reset switch 14 is arranged between a power supply potential node 5 supplying a power supply potential VDD and a node Nf serving as a floating diffusion, and turned on/off in response to a reset control signal RF. Transfer gate 12 is connected between a node N1 in which a signal charge is accumulated when a photocurrent is generated in photodiode PD, and node Nf. The on/off of transfer gate 12 is controlled by a transfer control signal TG.

Photodiode PD is arranged between a ground node 6 supplying a ground potential VSS and node N1. An anode of photodiode PD is biased to ground potential VSS in ground node 6. Node N1 corresponds to a cathode of photodiode PD. That is, in pixel circuit 10, the signal charge is an electron (negative charge) serving as a majority carrier at the cathode (n type).

In addition, according to this embodiment, when power supply potential VDD and ground potential VSS have a relation such that VDD>VSS, and the bias required for a circuit operation can be provided by a potential difference (VDD-VSS), the potentials can be set at any potential. That is, it is to be noted that ground potential VSS can be set at any potential (can be a negative potential) other than the ground potential.

Voltage amplifier 16 includes a source follower circuit, for example and its input node is connected to node Nf and its output node is connected to an output node No through pixel selection switch 18. On/off of pixel selection switch 18 is controlled by a pixel selection control signal PS.

According to the semiconductor image sensing device in the present invention, the plurality of pixel circuits 10 provided on a light receiving surface are arranged such that N (integral satisfying that N≥2) pixel circuits 10 form one group (pixel group). Then, an accumulated charge exhaust circuit 20 is arranged corresponding to each pixel group. According to the first embodiment, one pixel group is formed corresponding to four adjacent pixel circuits 10.

Accumulated charge exhaust circuit 20 is shared by N (four in this embodiment) pixel circuits 10 belonging to the same pixel group. Accumulated charge exhaust circuit 20 includes a node N2, a control switch 24, an inverting amplifier 26, and N discharge gates DG. An overflow drain capacitor 22 is formed in node N2.

Control switch 24 is connected between power supply potential node 5 and node N2 and turned on/off in response to a control signal RO. Inverting amplifier 26 is constituted such that a potential Vg of an output node (referred to as output potential Vg also hereinafter) is decreased as a potential of node N2 is increased, while output potential Vg is increased as the potential of node N2 is decreased.

Discharge gate DG is connected between node N1 in each pixel circuit 10 included in the same pixel group and node N2 in accumulated charge exhaust circuit 20, and functions as an equivalent variable resistance. Electric resistance of discharge gate DG is controlled based on output potential Vg of inverting amplifier 26. More specifically, each discharge gate DG is constituted such that as output potential Vg is increased, the electric resistance of each discharge gate DG is decreased, while output potential Vg is decreased, the electric resistance of each discharge gate DG is increased.

Fig. 2 shows an arrangement example of the pixel circuits and the accumulated charge exhaust circuit in each pixel group.

With reference to Fig. 2, photodiodes PD of pixel circuits 10 are arranged in an array of rows and columns (regions 30) in the light receiving surface for receiving incident light. Four pixel circuits 10 adjacent in an X direction and a Y direction form one pixel group 2 in the light receiving surface. The circuit elements other than photodiode PD in pixel circuit 10 are optionally arranged in regions 36 between regions 30 in which photodiodes PD are provided. In addition, transfer gate 12 of pixel circuit 10 is arranged in a boundary region 35 between region 30 and region 36.

Node N2 (overflow drain capacitor 22) in accumulated charge exhaust circuit 20 is formed in a region 34 surrounded by regions 30 of N (four) photodiodes PD included in one pixel group. In addition, discharge gate DG is arranged in a boundary region 32 between region 30 and region 34. The other circuit elements in accumulated charge exhaust circuit 20 are also arranged in region 36 appropriately.

Thus, in pixel group 2, accumulated charge exhaust circuit 20 is arranged in region 3 surrounded by N (four) pixel circuits 10 constituting the pixel group. In addition, a positional relation between node N2 (region 34) and photodiode PD (region 30) is common among pixel circuits 10 so that an operation of discharge gate DG as the variable resistance may be common.

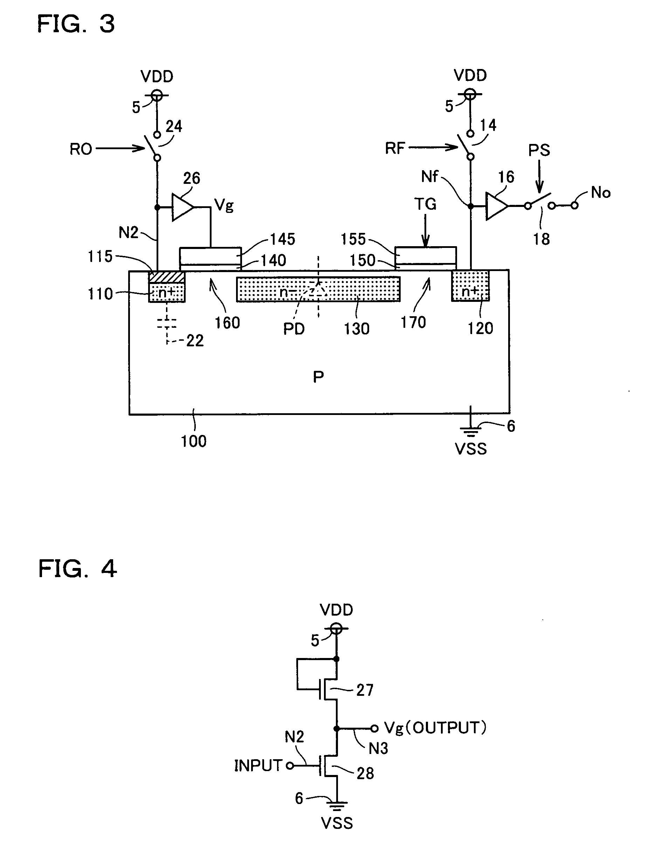

With reference to Fig. 3, a description will be made of a specific structure of pixel circuit 10 and accumulated charge exhaust circuit 20 shown in Fig. 1. Fig. 3 shows a structure example of one pixel circuit 10 in the same pixel group and accumulated charge exhaust circuit 20 connected thereto, and Fig. 3 is a sectional view taken along line III-III in Fig. 2.

With reference to Fig. 3, ground potential VSS is supplied from ground node 6 to a p type silicon substrate 100, as a substrate potential. On a main surface of p type silicon substrate 100, n+ diffusion regions 110 and 120 and a buried type n- diffusion region 130 are formed.

N+ diffusion region 110 corresponds to node N2 in Fig. 1, and a conductive light shielding plate 115 is formed on n+ diffusion region 110 (on the side of the light receiving surface). Overflow drain capacitor 22 is formed as a junction capacitor between p type silicon substrate 100 and n+ diffusion region 110.

A p type region is formed on buried n- diffusion region 130. Photodiode PD in Fig. 1 is formed by p-n junction between n- diffusion region 130 and its upper and lower p type regions. That is, according to the first embodiment, photodiode PD is provided as the buried diode.

A gate electrode 145 is formed above a channel region provided between n+ diffusion region 110 and n- diffusion region 130, with an insulation layer 140 interposed therebetween. Thus, an n-MOS transistor 160 is provided as a field effect transistor in which n- diffusion region 130 serves as a source, n+ diffusion region 110 serves as a drain, and gate electrode 145 serves as a gate. N-MOS transistor 160 constitutes discharge gate DG shown in Fig. 1.

Gate electrode 145 is connected to the output node of inverting amplifier 26. That is, a gate potential of n-MOS transistor 160 becomes output potential Vg of inverting amplifier 26. Inverting amplifier 26 is implemented by a circuit configuration shown in Fig. 4, for example.

With reference to Fig. 4, inverting amplifier 26 includes two n-MOS transistors 27 and 28 connected in series.

N-MOS transistor 27 is connected between an output node N3 in which output potential Vg is generated and power supply potential node 5, and its gate is connected to power supply potential node 5. Meanwhile, n-MOS transistor 28 is connected between output node N3 and ground node 6, and its gate is connected to node N2. Output node N3 is connected to gate electrode 145 shown in Fig. 3.

Thus, when control switch 24 is turned on and node N2 is connected to power supply potential VDD, node N3 is set to a low potential V1 higher than ground potential VSS by a certain potential. Meanwhile, a potential of input node N2 is decreased to ground potential VSS, it becomes a high potential Vh lower than power supply potential VDD by a certain potential. Thus, output potential Vg of inverting amplifier 26 varies within a range from low potential V1 (>VSS) to high potential Vh (<VDD), based on the potential of node N2 as an input.

With reference to Fig. 3 again, since the gate potential of n-MOS transistor 160 is controlled by inverting amplifier 260, when control switch 24 is turned on (Vg= V1), the electric resistance of each discharge gate DG reaches a maximum value Rh, and when control switch 24 is turned off, it is decreased as the potential of node N2 is decreased, to a minimum value R1 when Vg = Vh (that is, when node N2 is decreased to ground potential VSS). In addition, since n-MOS transistor 160 is not completely turned off even when control switch 24 is on, a transmission path of the signal charge from node N1 to node N2 can be formed.

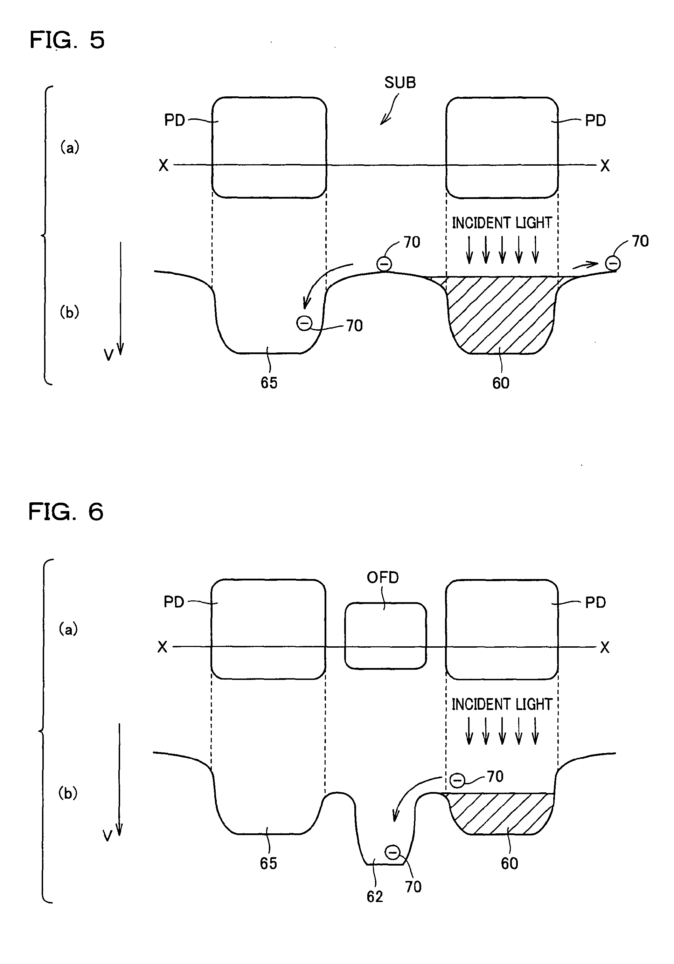

Since node N2 (that is, n+ diffusion region 110) is connected to power supply potential VDD while control switch 24 is on, node N2 serves as the overflow drain. Here, with reference to Figs. 5 and 6, an operation of the overflow drain will be described.

As shown in Figs. 5(a) and 5(b) showing a potential distribution along a line X-X in Fig. 5(a), when the incident light to photodiode PD is intense, since a signal charge 70 (negative charge) is generated in large quantity, a potential well 60 of the photodiode is filled with signal charge 70 and saturated. Thus, a phenomenon called blooming in which overflow signal charge 70 flows in a potential well 65 of the adjacent photodiode PD through a substrate region SUB and is detected as a false signal occurs.

Thus, as shown in Fig. 6(a) and 6(b) showing a potential distribution along a line X-X in Fig. 6(a), a lateral overflow drain OFD for absorbing overflow signal charge 70 from photodiode PD is arranged between photodiodes PD. Lateral overflow drain OFD is formed by biasing the impurity diffusion region having a predetermined conductivity type (n+ diffusion region 110 in Fig. 3) by a predetermined potential that can suck signal charge 70 (power supply potential VDD in this embodiment). As shown in the sectional view taken along line X-X, when lateral overflow drain OFD is provided, since signal charge 70 overflowing from photodiode PD can be absorbed, the blooming phenomenon (Fig. 5) can be prevented from being generated. The above-described lateral overflow drain is a method used in general as measures against the blooming similar to a vertical overflow drain in which the overflow drain is formed in a depth direction of the silicon substrate.

With reference to Fig. 3 again, n-diffusion region 110 is disconnected from power supply potential VDD while control switch 24 is off. Therefore, the signal charge overflowing from each photodiode PD (more specifically, node N1) of each pixel circuit 10 is accumulated in overflow drain capacitor 22 formed between p type silicon substrate 100 and n-diffusion region 110.

Therefore, when the incident light to each pixel circuit 10 in pixel group 2, that is, to pixel group 2 is intense, as the signal charge overflowing from each photodiode PD is accumulated, the potential of node N2 is decreased. Thus, as output potential of inverting amplifier 26 is increased, the electric resistance of discharge gate DG (the channel resistance of n-MOS transistor 160) is decreased, so that the charge exhaust operation from node N1 of each pixel circuit 10 to node N2 of accumulated charge exhaust circuit 20 is promoted.

Meanwhile, when the incident light to pixel group 2 is moderate and the signal charge does not overflow from each photodiode PD, the potential of node N2 is not decreased from power supply potential VDD. At this time, since output potential Vg of inverting amplifier 26 is not increased, the electric resistance of discharge gate DG (the channel resistance of n-MOS transistor 160) is maintained similar to the case where n+ diffusion region 110 functions as the overflow drain.

Thus, while an additionally required circuit element and its arrangement area are suppressed by using the overflow drain, accumulated charge exhaust circuit 20 can perform the charge exhaust operation.

Meanwhile, a gate electrode 155 is formed in a channel region between n+ diffusion region 120 and n- diffusion region 130, with an insulation film 150 interposed therebetween. Thus, an n-MOS transistor 170 is formed as a field effect transistor in which n- diffusion region 130 serves as a source, n+ diffusion region 120 serves as a drain, gate electrode 155 serves as a gate. N-MOS transistor 170 constitutes transfer gate 12 shown in Fig. 1.

Transfer control signal TG is inputted to gate electrode 155. While transfer control signal TG is at a high level (referred to as the H level also hereinafter), n-MOS transistor 170 is turned on in a saturated region or a linear region, and the signal charge accumulated in n- diffusion region 130 is transferred to n+ diffusion region 120. N+ diffusion region 120 is connected to power supply potential node 5 through reset switch 14, and connected to the input node of voltage amplifier 16. That is, n+ diffusion region 120 corresponds to node Nf as the floating diffusion shown in Fig. 1.

Thus, since transfer gate 12 (Fig. 1) is implemented by n-MOS transistor 170, the signal charge accumulated in n- diffusion region 130 can be taken out without providing a contact point directly contacting with n- diffusion region 130 physically. That is, when transfer gate 12 is provided, the present invention can be applied to a buried diode. According to the buried diode, since the accumulation node (node N1) for the signal charge is not directly connected to another node physically, high-accuracy photoelectric detection having a high noise resistance property can be expected.

Next, operations of pixel circuit 10 and accumulated charge exhaust circuit 20 will be described.

With reference to Fig. 1 again, photodiode PD in pixel circuit 10 generates a photocurrent based on the incident light of pixel circuit 10, and the signal charge (negative charge) is accumulated in node N1 based on the generation of the photocurrent.

As described above, accumulated charge exhaust circuit 20 fulfills different functions based on the on/off of control switch 24. While control switch 24 is on, since node N2 (n+ diffusion region 110 shown in Fig. 3) is connected to power supply potential VDD, and the overflow signal charge due to saturation is exhausted from photodiode PD, accumulated charge exhaust circuit 20 functions as the overflow drain shared by each pixel circuit 10 in the same pixel group.

Meanwhile, while control switch 24 is off period, accumulated charge exhaust circuit 20 accumulates the signal charge overflowing from photodiode PD of each pixel circuit 10 in the same pixel group and then generates the potential corresponding to the incident light quantity to the corresponding pixel group, in node N2. Thus, when the incident light is intense (in large light quantity) and the electric resistance of discharge gate DG is decreased as the potential of node N2 is decreased, accumulated charge exhaust circuit 20 executes the "signal charge exhaust operation" in which the signal charge accumulated in node N1 of each pixel circuit 10 up to that time is exhausted to node N2. Meanwhile, when the incident light is moderate (in small light quantity), since the potential of node N2 is not decreased, the electric resistance of discharge gate DG is maintained at high resistance, so that accumulated charge exhaust circuit 20 does not execute the above signal charge exhaust operation. Thus, the charge exhaust operation by accumulated charge exhaust circuit 20 is likely to be executed as the signal charge overflowing from pixel circuit 10 is increased, that is, as the incident light to corresponding pixel group 2 becomes intense. Consequently, accumulated charge exhaust circuit 20 exhausts the signal charge corresponding to the incident light quantity to the pixel group, from node N1 in pixel circuit 10 in the same pixel group.

In pixel circuit 10, when transfer gate 12 is turned on in the saturated region or the linear region according to transfer control signal TG, the signal charge accumulated in node N1 for one frame period is transferred to node Nf. Node Nf is precharged to power supply potential VDD when reset switch 14 is turned on and then after reset switch 14 is turned off, Node Nf receives and accumulates the signal charge transferred from transfer gate 12. Transfer gate 12 is turned on based on an output timing provided corresponding to switching of the one frame period.

As a result, a potential corresponding to the signal charge quantity accumulated in node N1 is generated in node Nf as the floating diffusion at the output timing for the one frame period. Voltage amplifier 16 generates an output voltage corresponding to the potential of node Nf and is connected to output node No through pixel selection switch 18 turned on based on pixel selection control signal PS. Thus, an output voltage signal Vout corresponding to the signal charge quantity accumulated in node N1 for the one frame period is outputted to output node No.

**[0068]** According to a characteristic point of the present invention, since an off period of control switch 24 (referred to as the charge exhaust period also hereinafter) is provided occasionally during the one frame period, in the case where the incident light is intense and the signal charge of node N1 is saturated in the middle of the one frame period, the signal charge accumulated in node N1 can be exhausted in the middle of the one frame period by the signal charge exhaust operation by accumulated charge exhaust circuit 20.

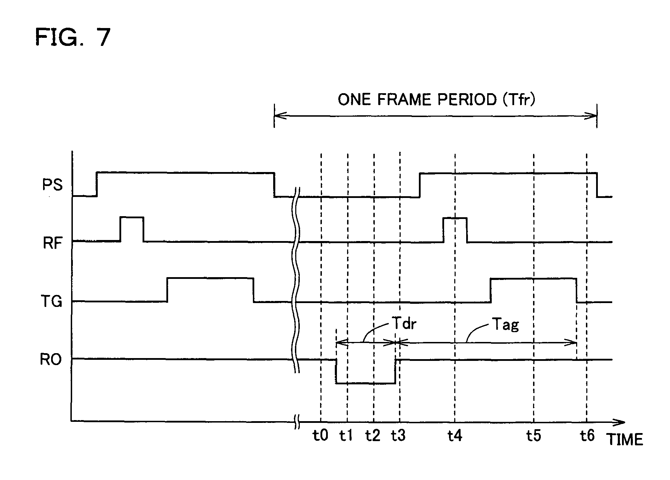

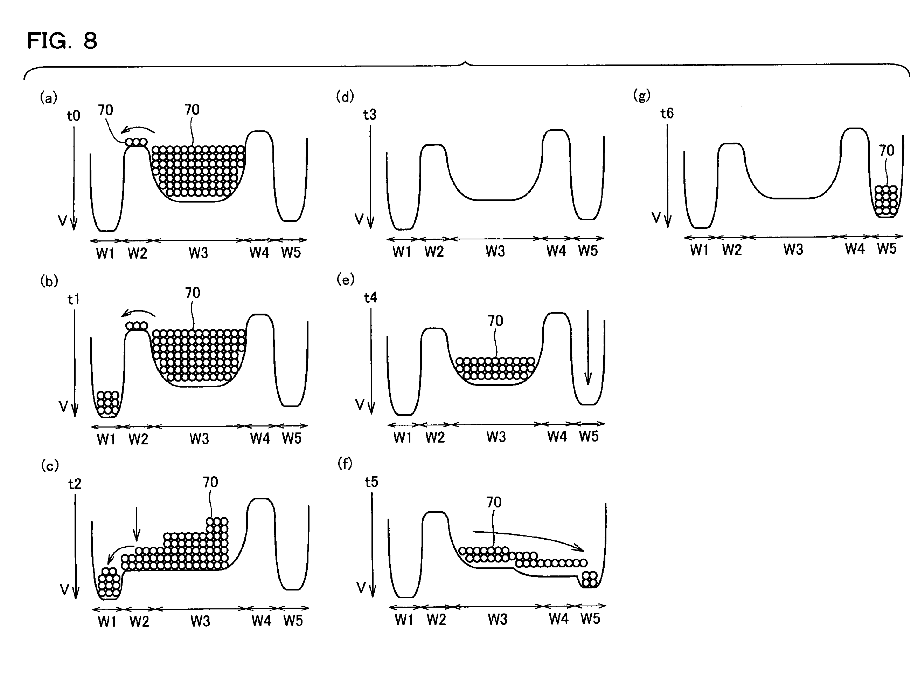

Next, with reference to Figs. 7 and 8, an operation of the semiconductor image sensing device according to the first embodiment for the one frame period will be described.

With reference to Fig. 7, pixel selection control signal PS, reset control signal RF, transfer control signal Tg, and control signal RO are set so as to transit from a high level (H level) to a low level (L level) or from the L level to the H level at a certain timing for each frame period.

Transfer gate 12, reset switch 14, pixel selection switch 18 and control switch 24 are turned on for the H level period of transfer control signal TG, reset control signal RF, pixel selection control signal PS and control signal RO, respectively and turned off for the L level period of those.

Pixel selection control signal PS is set to H level for a certain period corresponding to the switching of the frame period. During the H level period (pixel selection period) of pixel selection control signal PS, after reset control signal RF is set to the H level and the signal charge of node Nf is cleared, the H level period (transfer period) of transfer control signal TG is provided. During this transfer period, the accumulated signal charge of node N1 for the one frame period is transferred to node Nf, and output voltage signal Vout corresponding to the accumulated signal charge quantity at this timing is generated from voltage amplifier 16.

Furthermore, during the one frame period, prior to the pixel selection period, the L level period of control signal RO (charge exhaust period) is provided at a certain timing. As described above, during the charge exhaust period, accumulated charge exhaust circuit 20 executes the charge exhaust operation based on the incident light quantity to the pixel group.

Fig. 8 is a schematic view showing formation of a potential barrier and movement of the signal charge at times t0 to t6 in Fig. 7.

In Fig. 8, a vertical axis designates a height of the potential barrier. In a horizontal axis, W1 corresponds to an arrangement region of overflow drain capacitor 22 (node N2), W2 corresponds to a channel region of discharge gate DG (n-MOS transistor 160), W3 corresponds to an arrangement region of photodiode PD, W4 corresponds to the channel region of transfer gate 12 (n-MOS transistor 170), and W5 corresponds to the floating diffusion region (node Nf).

At time t0, pixel selection control signal PS, reset control signal RF, and transfer control signal TG are set to the L level, and control signal RO is set to the H level. Thus, in accumulated charge exhaust circuit 20 shown in Fig. 1, node N2 functions as the overflow drain when control switch 24 is turned on. Meanwhile, in pixel circuit 10, transfer gate 12 and reset switch 14 are turned off, and the signal charge is accumulated in node N1 by the optical current generated from photodiode PD based on the incident light quantity to pixel circuit 10. In addition, since photodiode PD constantly generates the photocurrent corresponding to the incident light quantity to that pixel circuit 10, the accumulation operation of the signal charge in node N1 is constantly executed during the one frame period.

With reference to Fig. 8(a), at time t0, region W1 corresponding to node N2 (overflow drain capacitor 22) is biased to power supply potential VDD. Therefore, overflow signal charge 70 due to saturation is exhausted from photodiode region W3 without being accumulated in overflow drain capacitor 22 (region W1). At this time, it is necessary to set the potential of region W2, that is, the region under the discharge gate to be lower than a built-in voltage forming a bottom of a potential well of photodiode PD so as not to draw all the signal charge from photodiode PD (region W3). This is equivalent of appropriately designing electric resistance Rh of discharge gate DG as the above-described variable resistance element when control switch 24 is on (Vg = VI).

With reference to Fig. 7 again, during time t 1 to t2 of charge exhaust period Tdr in which control signal RO transits from the H level at time t0 to the L level, control switch 24 in accumulated charge exhaust circuit 20 is turned off. Thus, the signal charge overflowing from node N1 of pixel circuit 10 is accumulated by overflow drain capacitor 22 in node N2.

With reference to Fig. 8(b), at time t1, when region W1 (node N2) is disconnected from power supply potential VDD, accumulation of overflow charge from photodiode region W3 (node N1) is started.

With reference to Fig. 8(c), at time t2, as the signal charge overflowing from photodiode region W3 (node N1) is accumulated in overflow drain capacitor part W1 (node N2), the potential of the region W2 under the discharge gate is increased. As a result, this is equivalent of lowering of the resistance of discharge gate DG, so that the signal charge exhaust operation from node N1 in pixel circuit 10 is promoted.

Here, when it is assumed that there is no potential barrier and pocket that prevent the charge from being exhausted to photodiode PD, and a maximum value of the potential of region W2 under the discharge gate does not exceed the built-in voltage of the photodiode, movement of the signal charge from photodiode region W3 to region W1 (node N2) can be modeled by a subthreshold current formula of n-MOS transistor 160 as shown in the following formula (1).

$$Ids = Id0 \cdot \exp \{q/(n \cdot k \cdot T) \cdot (Vg-Vs-Vt)\} \cdots (1)$$

Here, it is to be noted that Id0 is expressed by the following formula (2).

$$Id0 = (W/L) \cdot \mu n \cdot C0 \cdot (k \cdot T/q) \cdot \exp (1) \cdots (2)$$

In addition, in the formulas (1) and (2), q designates an elementary charge, k designates a Boltzmann coefficient, T designates an absolute temperature, $\mu n$ designates a carrier mobility (electron) and W and L designate a gate width and a gate length of n-MOS transistor 160, respectively. In addition, Vs designates a photodiode potential (potential of node N1), and Vt designates a threshold voltage of n-MOS transistor 160. In addition, n is a coefficient expressed by n = (C0 + Cd)/C0 where C0 and Cd are a gate insulation film capacitance and a depletion layer capacitance of n-MOS transistor 160, respectively.

Thus, during the charge exhaust period, subthreshold current Ids generated in n-MOS transistor 160, that is, the signal charge quantity exhausted from node N1 to node N2 per unit time depends on output potential Vg of inverting amplifier 26 in conformity to the potential of node N2 based on the incident light quantity to the pixel group.

Here, when it is assumed that a saturation signal charge quantity at photodiode PD (node N1) is Q, the potential at each point when signal charge quantity Q is accumulated in node N1 can be found from a circuit constant such as capacitance value, and by relating to an estimation value of subthreshold current Ids at this time, a time required for exhausting all the saturated signal charge quantity Q from node N1 by accumulated charge exhaust circuit 20 can be previously estimated. Therefore, a length of the charge exhaust period can be set by relating to this prescribed time. In addition, since the charge exhaust period can be provided by setting control signal RO, it may be provided not only one time but also several times during the one frame period.

With reference to Fig. 7 again, when control signal RO transits from the L level to the H level between time t2 and time t3, control switch 24 is turned on again and the state at time t0 is reproduced. Thus, the signal charge corresponding to the incident light quantity is accumulated in node N1 of pixel circuit 10 again.

With reference to Fig. 8(d), at time t3 when the accumulation operation of the signal charge resumed, that is, at the end of charge exhaust period Tdr, in the case where the incident light is intense, as it is shown, the signal charge exhaust operation is executed by accumulated charge exhaust circuit 20 during charge exhaust period Tdr and then the signal charge of photodiode region W3 (node N1) is cleared once. Meanwhile, although it is not shown, when the incident light to the pixel group is moderate, the signal charge exhaust operation is not executed by accumulated charge exhaust circuit 20 and the signal charge accumulated in photodiode region W3 (node N1) up to this time is remained as it is. In addition, in an intermediate incident light region, a part of the signal charge accumulated in node N1 until then is remained. Thus, during charge exhaust period Tdr, the signal charge corresponding to the incident light quantity to the pixel group is exhausted from photodiode region W3 (node N1) by accumulated charge exhaust circuit 20.

With reference to Fig. 7 again, during the pixel selection period in which pixel selection control signal PS is at the H level, first, reset control signal RF is set to the H level for a certain period, and node Nf as the floating diffusion is connected to power supply potential VDD when reset switch 14 is turned on (time t4).

Furthermore, during the transfer period in which transfer control signal TG is set to the H level, transfer gate 12 is turned on and the signal charge accumulated in node N1 until then is transferred to node Nf (time t5). Then, when transfer control signal TG is returned to the L level and the transfer period is completed, transfer gate 12 is turned off (time t6). Then, when pixel selection control signal PS returns to the L level and the pixel selection period is completed, the operation for the one frame period is completed.

With reference to Fig. 8(e), at time t4, the signal charge accumulated in node N1 after charge exhaust period Tdr is retained in photodiode region W3 (node N1). Meanwhile, floating diffusion region W5 (node Nf) is connected to power supply potential VDD and the signal charge accumulated in this region is cleared.

With reference to Fig. 8(f), at time t5, when transfer gate 12 is turned on, the potential of region W4 under the transfer gate is increased and the signal charge accumulated in photodiode region W3 (node N1) until then for the one frame period is transferred to floating diffusion region W5 (node Nf).

When the incident light is intense and the signal charge exhaust operation is completely executed during charge exhaust period Tdr, the transferred signal charge quantity is the signal charge quantity accumulated in a re-accumulation period Tag (Fig. 7) after charge exhaust period Tdr, and when the incident light is moderate and the signal charge exhaust operation is not executed during charge exhaust period Tdr, the signal charge accumulated for the one frame period is obtained.

With reference to Fig. 8(g), at time t6, since transfer gate 12 is turned off and the potential of region W4 under the transfer gate is decreased, the signal charge transferred from photodiode region W3 (node N1) is accumulated in floating diffusion region W5 (node Nf). As a result, the potential of floating diffusion region W5 (node Nf) corresponds to the accumulated signal charge quantity at this time, that is, the accumulated signal charge quantity of node N1 at the end of the one frame period, and output voltage signal Vout corresponding to the potential of node Nf at this time is outputted from output node No. In addition, at time t6, the accumulated signal charge in photodiode region W3 (node N1) is cleared once in response to the switching of the one frame period.

As described above, according to the semiconductor image sensing device in this first embodiment, the signal charge accumulated in each pixel circuit can be exhausted once at the intermediate timing (charge exhaust period) during the one frame period by the accumulated charge exhaust circuit provided corresponding to each pixel group, when the incident light to the pixel group is intense (at the time of high illumination). Therefore, when the illumination is high, a dynamic range in each pixel circuit 10 can be enlarged based on a ratio k ( = (Tfr/Tag) of one frame period Tfr to re-accumulation period Tag from the end of the charge exhaust period (when there are a plurality of number of that periods, the last charge exhaust period) until the end of the transfer period.

Meanwhile, when the incident light to the pixel group is moderate (at the time of low illumination), the signal charge exhaust operation is not executed by accumulated charge exhaust circuit 20, and an image can be taken in sufficient contrast without enlarging the dynamic range of each pixel circuit 10.

As a result, a contrast between a bright part and a dark part can be sufficiently detected even when a luminance distribution in a visual field is large, by enlarging the dynamic range at the time of high illumination with a simple circuit configuration in which the one photodetection element (photodiode) is provided in each pixel circuit 10 and the light quantity is detected only based on the accumulation quantity of the signal charge generated by the light receiving element.

Here, photodiode PD in pixel circuit 10 corresponds to a "first photodetection element" in the present invention, and node N1 corresponds to a "first node" in the present invention. In addiction, transfer gate 12 corresponds to a "first initialization circuit" in which the accumulated charge in node N1 is cleared, and reset switch 14 corresponds to a "second initialization circuit" in the present invention. Furthermore, voltage amplifier 16 corresponds to a "readout circuit" in the present invention. In addition, this "readout circuit" can be arranged so as to be shared by the plurality of pixel circuits 10, as an external element of pixel circuit 10, for example.

In addition, node N2 in accumulated charge exhaust circuit 20 corresponds to a "second node" in the present invention, power supply potential node 5 corresponds to a "potential node" in the present invention, and inverting amplifier 26 corresponds to a "control potential generation unit" in the present invention, and control switch 24 corresponds to a "control switch element" in the present invention.

Furthermore, in Fig. 3, n- diffusion region 130 corresponds to a "first impurity diffusion region" in the present invention, n+ diffusion region 110 corresponds to a "second impurity diffusion region" in the present invention, and n+ diffusion region 120 corresponds to a "third impurity diffusion region" in the present invention. In addition, n- MOS transistor 160 corresponds to a "first field effect transistor" in the present invention, and n- MOS transistor 170 corresponds to a "second field effect transistor" in the present invention.

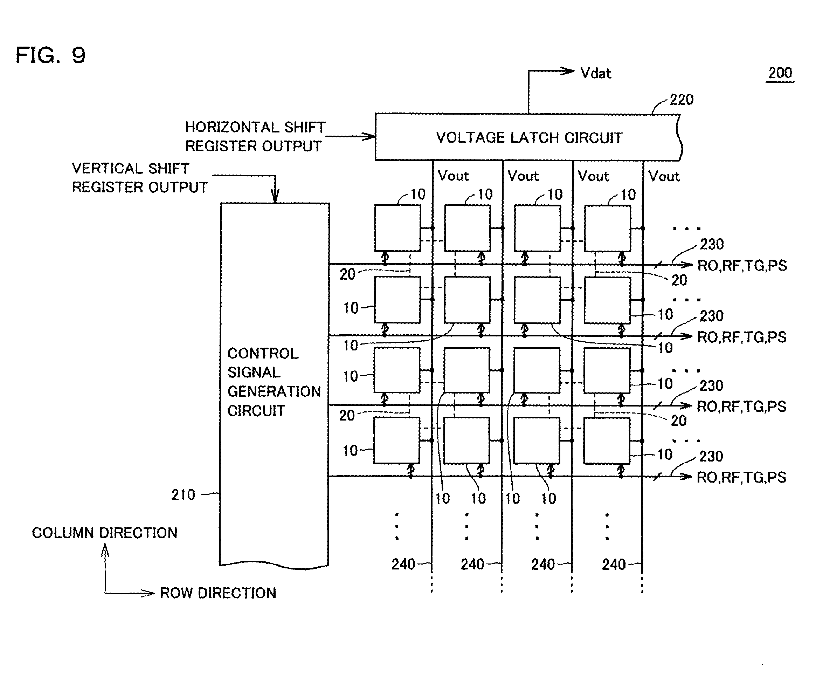

Fig. 9 is a block diagram showing an entire configuration of a semiconductor image sensing device according to the first embodiment in which the pixel circuits and the accumulation charge exhaust circuits according to the first embodiment are arranged in an array of rows and columns.

With reference to Fig. 9, a semiconductor image sensing device 200 according to this embodiment includes the plurality of pixel circuits 10 arranged in the array of rows and columns on a light receiving surface for receiving the incident light, accumulated charge exhaust circuit 20 arranged corresponding to each pixel group made of four pixel circuits 10 adjacent to each other in a row direction and a column direction, a control signal generation circuit 210, a voltage latch circuit 220, a signal line 230 extending in the row direction, and a data line 240 extending in the column direction.

Control signal generation circuit 210 generates a control signal group including pixel selection control signal PS, reset control signal RF, transfer control signal TG, and control signal RO described in Fig. 7, with respect to each pixel row, based on an output of a vertical shift resister (not shown) for performing a scanning operation in a vertical direction (column direction) every one frame period.

The control signal group generated by control signal generation circuit 210 is transmitted by signal line 230, and received by each pixel circuit 10 and each accumulated charge exhaust circuit 20 in the same pixel row.

Data line 240 is provided corresponding to each pixel column, and connected to output node No of pixel circuit 10 in the corresponding pixel column. Voltage latch circuit 220 is connected to each data line 240, and can obtain output voltage signal Vout from each pixel circuit 10 in a scanning order of pixel circuit by reading a voltage on data line 240 sequentially, by performing a scanning operation in a horizontal direction (row direction) based on an output of a horizontal shift register (not shown). Thus, a data column signal Vdat in which output voltage signals Vout from each pixel circuit 10 are arranged serially, based on the scanning order of pixel circuits 10 can be obtained.

In addition, in the case where the pixel circuits belonging to the same pixel group are arranged over the plurality of (two) pixel rows like in this embodiment, it is preferable that the control signal group is set at a common timing in the plurality of (two) pixel rows belonging to the same pixel group. In this case, since output voltage signals Vout are outputted from the plurality of (two) pixel circuits 10 belonging to the same pixel group in each pixel column, it is necessary to provide the plurality of (two) data lines 240 with respect to each pixel column and connect the plurality of (two) data lines 240 to the plurality of (two) pixel circuits 10 belonging to the same group. Consequently, the readout operation can be executed with higher accuracy.

In addition, the configurations for scanning and taking out the output voltage signal of each pixel circuit 10 according to this embodiment of the present invention is not limited to the illustration shown in Fig. 9, and it is to be noted that any method known to those skilled in the art can be occasionally used. In addition, the pixel groups sharing accumulated charge exhaust circuit 20 may be provided over any number of pixel rows and pixel columns.

(Variation of first embodiment)

Although the semiconductor image sensing device includes pixel circuit 10 having photodiode PD as a buried diode in the first embodiment, the present invention can be applied to a pixel circuit having a photodiode other than the buried diode.

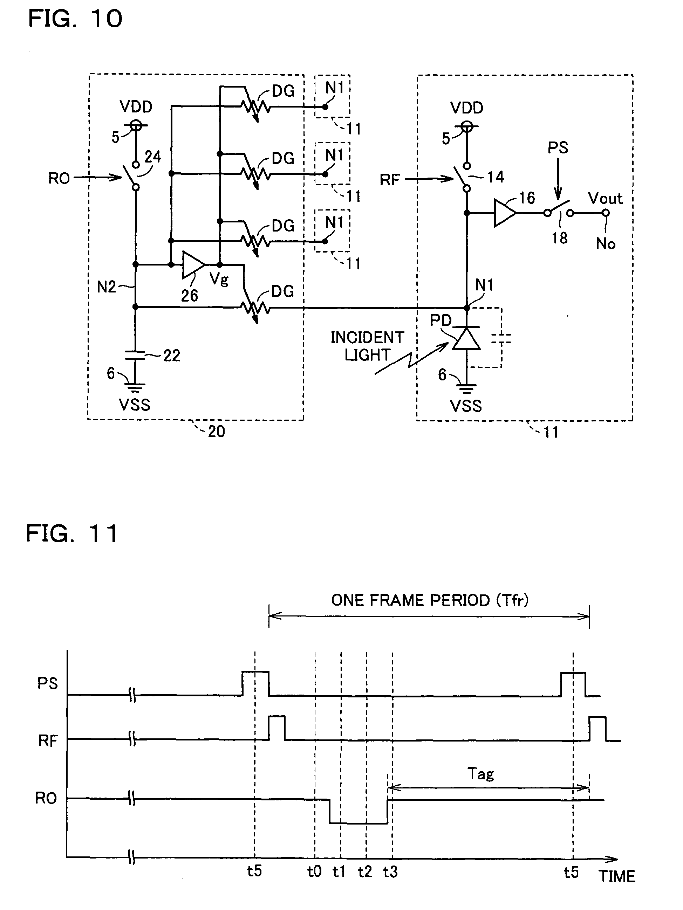

As shown in Fig. 10, even when pixel circuit 10 shown in Fig. 1 is replaced with a pixel circuit 11, a semiconductor image sensing device in which accumulated charge exhaust circuit 20 is shared by the plurality of pixel circuits 11 in the same pixel group can be provided similar to the first embodiment.

With reference to Fig. 10, pixel circuit 11 differs from pixel circuit 10 shown in Fig. 1 in that transfer gate is not provided. That is, reset switch 14 is connected so as to reset node N1 directly, and the input node of voltage amplifier 16 is directly connected to node N1.

Therefore, according to pixel circuit 11, in the structure shown in Fig. 6, photodiode PD is not limited to the buried diode and can be a normal p-n junction diode. In this case, since the n type diffusion region corresponding to node N1 is provided on a main surface of p type silicon substrate 100, a contact point directly contacting with node N1 physically can be formed. Therefore, even when transfer gate 12 shown in Fig. 1 (n-MOS transistor 170 in Fig. 6) is not provided in pixel circuit 11, the semiconductor image sensing device similar to that in the first embodiment can be provided.

Consequently, in pixel circuit 11, reset switch 14 corresponds to the "first initialization circuit" in the present invention, and the "second initialization circuit" in the present invention is not provided.

With reference to Fig. 11, an operation of the semiconductor image sensing device according to the variation of the first embodiment in which pixel circuit 11 is provided will be described.

With reference to Fig. 11, according to the semiconductor image sensing device in the variation of the first embodiment, while control signal RO is set similar to the first embodiment (Fig. 7), pixel selection control signal PS is set to the H level at a timing corresponding to time t5 shown in Fig. 7. Thus, reset control signal RF is set to the H level at the start of a new one frame period, in response to the end of the pixel selection period (the H level period of pixel selection control signal RS) so as to correspond to the switching of the one frame period. Thus, the accumulated signal charge in node N1 can be cleared at the time of the start of each frame period.

Although the potential of node N1 and the output voltage of voltage amplifier 16 constantly vary depending on the accumulated quantity of the signal charge in node N1 during the one frame period, when the L level period of control signal RO (charge exhaust period) is provided in the middle of the one frame period and accumulated charge exhaust circuit 20 exhausts the signal charge occasionally, output voltage signal Vout can be generated from pixel circuit 11 similar to pixel circuit 10 in the first embodiment.

(Second embodiment)

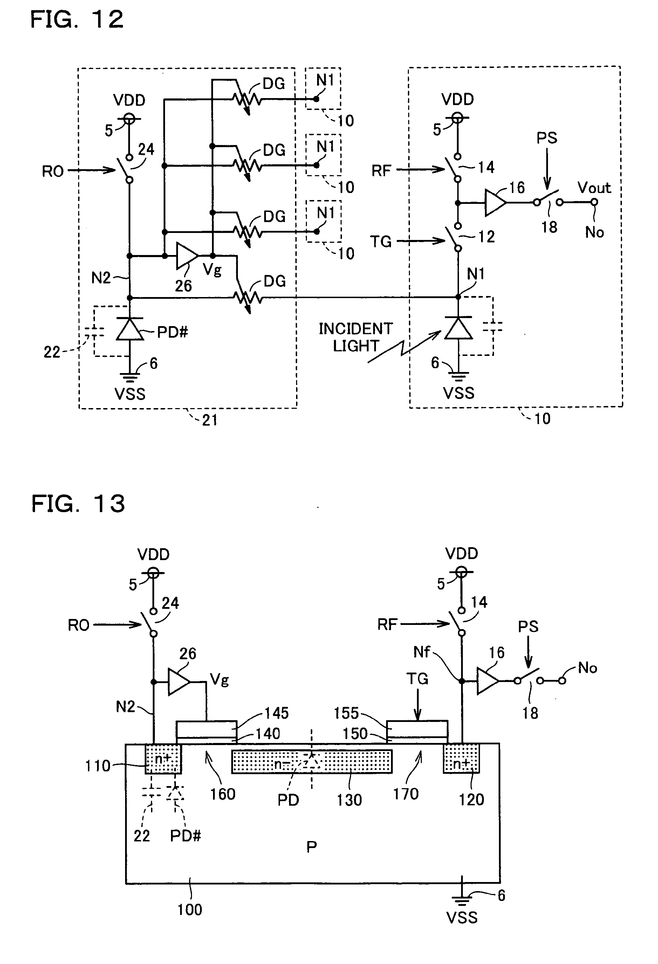

Fig. 12 is a circuit diagram for describing a configuration of a pixel circuit and an accumulated charge exhaust circuit in a semiconductor image sensing device according to a second embodiment.

With reference to Fig. 12, according to the semiconductor image sensing device in the second embodiment, an accumulated charge exhaust circuit 21 is provided instead of accumulated charge exhaust circuit 20 shown in Fig. 1.

Accumulated charge exhaust circuit 21 has a circuit configuration in which a photodiode PD# as the "second photodetection element" is arranged between node N2 and ground node 6 in accumulated charge exhaust circuit 20 shown in Fig. 1.

Fig. 13 is a sectional view showing a structure of a main part of accumulated charge exhaust circuit 21 and corresponding to a sectional view showing the main part of accumulated charge exhaust circuit 21 shown in Fig. 3. As can be understood from comparison between Fig. 13 and Fig. 3, accumulated charge exhaust circuit 21 has a structure in which light shielding plate 115 on the main surface of n+ diffusion region 110 serving as the overflow drain is not arranged. Thus, photodiode PD# in which p type silicon substrate 100 biased to ground potential VSS serves as an anode and n+ diffusion region 110 serves as a cathode is formed. Since other configuration and structure in accumulated charge exhaust circuit 21 is similar to that of accumulated charge exhaust circuit 20, they will not be repeated in detail.

Accumulated charge exhaust circuit 21 is provided corresponding to each pixel group similar to the first embodiment, and it is electrically connected to each node N1 of pixel circuit 10 included in the same pixel group through a discharge gate DG.

With reference to Fig. 12 again, according to accumulated charge exhaust circuit 21, since n+ diffusion region 110 is biased to power supply potential VDD during the on period of control switch 24, n+ diffusion region 110 serves as the overflow drain similar to accumulated charge exhaust circuit 20 in the first embodiment. Meanwhile, during the off period of control switch 24 (charge exhaust period), photodiode PD# generates a photocurrent according to a quantity of an incident light to accumulated charge exhaust circuit 21, that is, an incident light to the pixel group, and a signal charge can be accumulated in node N2 as the photocurrent is generated.

At this time, when node N2 (that is, photodiode PD#) is provided in a region surrounded by the pixel circuits belonging to the same pixel group, at the same distance from each pixel circuit substantially, similar to the layout shown in Fig. 2, photodiode PD# can generate the photocurrent corresponding to the average incident light quantity of the pixel group by direct exposure.

Thus, in addition to the signal charge overflowing from pixel circuit 10 during the charge exhaust period similar to the first embodiment, a signal charge generated by photodiode PD# is also accumulated in node N2 in accumulated charge exhaust circuit 21. Therefore, since the signal charge is likely to be accumulated in node N2 in accumulated charge exhaust circuit 21, the signal charge can be likely to be exhausted from node N1 and the exhausting speed of the signal charge can be increased.

As a result, since the one frame period required for obtaining the same dynamic range at the time of high illumination can be relatively shortened, the image can be taken at high speed.

As another example, a configuration in which the potential of node N2, that is, the resistance of discharge gate DG can be controlled based on only the light quantity detected by photodiode PD# during the charge exhaust period can be implemented in principle. In this configuration, a charge exhaust unit (not shown) for exhausting the signal charge from node N1 of pixel circuit 10 is separately provided in accumulated charge exhaust circuit 21, and each discharge gate DG is disconnected from node N2 and connected between the charge exhaust port and node N1 in pixel circuit 10.

In addition, according to the semiconductor image sensing device in the second embodiment, pixel circuit 10 may be replaced with pixel circuit 11 shown in the variation of the first embodiment. That is, the semiconductor image sensing device according to the second embodiment can be provided by arranging pixel circuit 10 or 11 and accumulated charge exhaust circuit 21 according to the second embodiment as shown in Fig. 9, for example.

(Third Embodiment)

As described above, the semiconductor image sensing device according to the embodiment of the present invention can be provided by combining pixel circuit 10 or 11 and accumulated charge exhaust circuit 20 or 21. Here, although the circuit configuration in which the anode of photodiode PD is fixed to ground potential VSS in the first and second embodiments, the present invention can be applied to a circuit configuration in which a polarity of each circuit is inverted and the cathode of photodiode PD is fixed to power supply potential VDD.

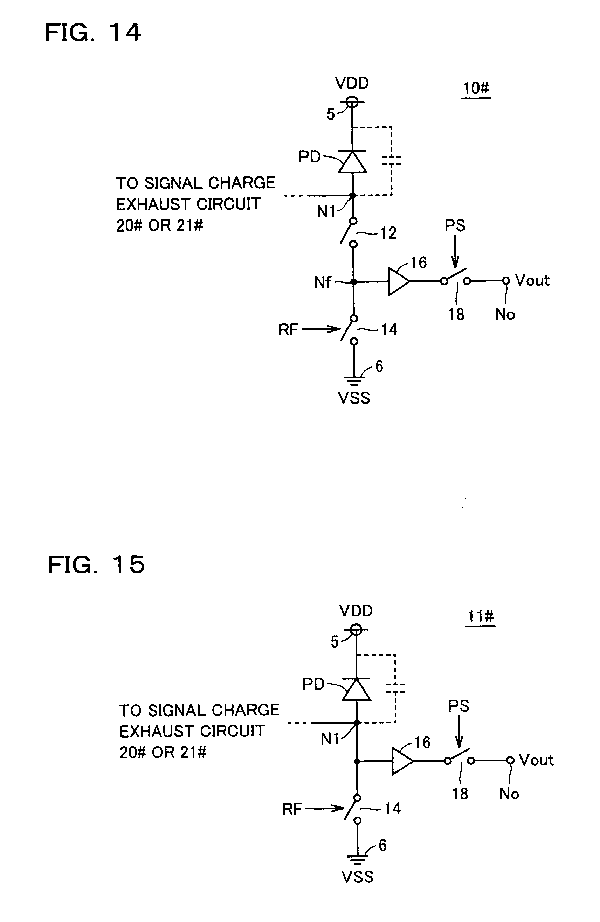

Figs. 14 and 15 show pixel circuits 10# and 11# according to a third embodiment as a variation in which polarities of pixel circuit 10 and 11 are inverted, respectively.

According to pixel circuits 10# and 11#, the cathode of photodiode PD is connected to power supply potential node 5, and as compared with pixel circuits 10 and 11, arrangements of the circuit elements connected between node N1, and power supply potential node 5 and ground node 6 are exchanged. In addition, since node N1 corresponds to the anode of the photodiode in pixel circuits 10# and 11#, the accumulated signal charge is a positive charge.

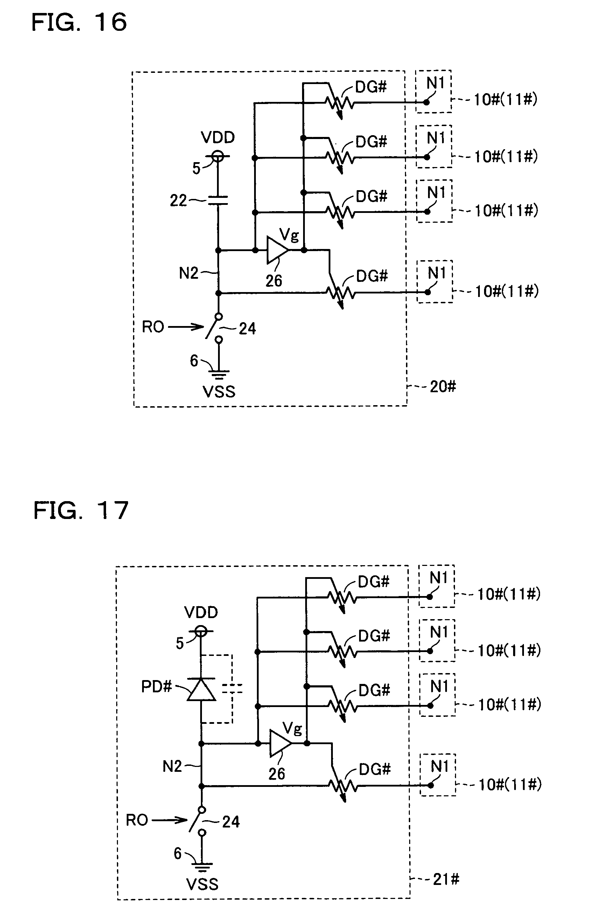

Figs. 16 and 17 show accumulated charge exhaust circuits 20# and 21# according to the third embodiment as a variation in which polarities of accumulated charge exhaust circuits 20 and 21 are inverted, respectively. According to accumulated charge exhaust circuits 20# and 21#, the arrangements of the circuit elements connected between node N1, and power supply potential node 5 and ground node 6 are exchanged as compared with accumulated charge exhaust circuits 20 and 21.

In addition, a discharge gate DG# for exhausting the positive charge from node N1 is connected between node N1 in pixel circuit 10# (or 11#), and node N2 in accumulated charge exhaust circuit 20# (or 21#) instead of discharge gate DG. Electric resistance of discharge gate DG# is decreased as output potential Vg of inverting amplifier 26 is decrease (that is, the potential of node N2 is increased) and its electric resistance is increased as output potential Vg is increased, contrary to discharge gate DG.

According to pixel circuits 10# and 11# and accumulated charge exhaust circuits 20# and 21#, n type and p type conductivity types can be inverted as needed in the structure examples shown in Fig. 6 or 13. That is, transfer gates 12 in pixel circuits 10# and 11# are made of the p-MOS transistors, and discharge gates DG in accumulated charge exhaust circuits 20# and 21# are made of the p-MOS transistors.

Since the operations and functions in pixel circuits 10# and 11# and accumulated charge exhaust circuits 20# and 21# are similar to those in pixel circuits 10 and 11 and accumulated charge exhaust circuits 20 and 21, those will not be repeated in detail. That is, the semiconductor image sensing device according to the embodiment of the present invention can be provided by combining pixel circuit 10# or 11# and accumulated charge exhaust circuits 20# or 21#. However, since the mobility of the positive charge (positive hole) is smaller than that of the negative charge (electron), the semiconductor image sensing device having pixel circuit 10 or 11 and accumulated charge exhaust circuit 20 or 21 is relatively advantageous in view of high-speed imaging as compared with the semiconductor image sensing device having pixel circuit 10# or 11# and accumulated charge exhaust circuit 20# or 21#.

It should be understood that the embodiments and examples disclosed herein are illustrative and nonrestrictive in every respect. The scope of the present invention is defined by the terms of the claims, rather than the description above, and is intended to include any modification within the scope and meaning equivalent to the terms of the claims.

INDUSTRIAL APPLICABILITY

As described above, the semiconductor image sensing device according to the present invention can be used in various circumstances as the image sensing device having a high vision sensing ability, and can be used as a monitoring camera including outdoor application and an in-car camera. In addition, since a pixel size can be minified because of the simple circuit configuration, the semiconductor image sensing device according to the present invention is suitable for a case where the number of pixels is increased and also suitable for being mounted on a mobile device.

**Claims**

1. A semiconductor image sensing device comprising:

   a plurality of pixel circuits divided into a plurality of pixel groups; and
   an accumulated charge exhaust circuit provided corresponding to each said pixel group, wherein
   each of said pixel groups includes a plurality of said pixel circuits,
   each of said pixel circuits includes:

   a first photodetection element for generating a signal charge corresponding to an incident light quantity to the pixel circuit;
   a first node having predetermined capacitance and being accumulated said signal charge generated by said first photodetection element; and
   a first initialization circuit for clearing said signal charge accumulated in said first node in response to switching of a frame period,
   said accumulated charge exhaust circuit is configured to execute a signal charge exhaust operation for exhausting said signal charge from said first node, based on an incident light quantity to the corresponding pixel group, during a charge exhaust period previously set at a predetermined timing during each said frame period,
   said signal charge exhaust operation is executed such that a signal charge quantity exhausted from said first node per unit time is relatively increased as the incident light quantity to said corresponding pixel group is increased, and
   said semiconductor image sensing device further comprises a readout circuit configured to output an electric signal corresponding to said signal charge quantity accumulated in said first node, at an output timing set at a predetermined timing after said charge exhaust period during each said frame period, from each of said pixel circuits.

2. The semiconductor image sensing device according to claim 1, wherein
   said accumulated charge exhaust circuit includes:

   a second node having predetermined capacitance and configured to accumulate said signal charges exhausted from said first node in each of the plurality of pixel circuits included in the pixel group when said signal charge is saturated in said first node;
   a control potential generation unit generating a control potential varying depending on a potential of said second node;
   a potential node supplying a predetermined potential to suck said signal charge;
   a control switch element provided between said potential node and said second node and turned off during said charge exhaust period while turned on outside said charge exhaust period; and
   a discharge gate connected between said first node and said second node in the pixel group, and controlling a quantity of an exhaust current of said signal charge overflowing from said first node to said second node based on said control potential, and
   said discharge gate is configured to increase said exhaust current as said control potential varies when the potential of said second node varies based on an accumulated quantity of said signal charge in said second node during said charge exhaust period.

**3.** The semiconductor image sensing device according to claim 1, wherein said accumulated charge exhaust circuit includes:

a second photodetection element for generating a signal charge corresponding to an incident light quantity to the accumulated charge exhaust circuit;

a second node having predetermined capacitance and configured to accumulate said signal charges exhausted from said first node in each of the plurality of pixel circuits included in the pixel group when said signal charge is saturated in said first node, and said signal charge generated from said second photodetection element;

a control potential generation unit generating a control potential varying depending on a potential of said second node;

a potential node supplying a predetermined potential to suck said signal charge;

a control switch element provided between said potential node and said second node, and turned off during said charge exhaust period while turned on outside said charge exhaust period; and

a discharge gate connected between said first node and said second node in the pixel group, and controlling a quantity of an exhaust current of said signal charge overflowing from said first node to said second node based on said control potential, and

said discharge gate is configured to increase said exhaust current as said control potential varies when the potential of said second node varies based on an accumulated quantity of said signal charge in said second node during said charge exhaust period.

**4.** The semiconductor image sensing device according to claim 1, including:

a second photodetection element for generating a signal charge corresponding to an incident light quantity to the accumulated charge exhaust circuit;

a second node having predetermined capacitance and configured to accumulate said signal charge generated from said second photodetection element;

a control potential generation unit generating a control potential varying depending on a potential of said second node;

a potential node supplying a predetermined potential to suck said signal charge;

a control switch element provided between said potential node and said second node, and turned off during said charge exhaust period while turned on outside said charge exhaust period; and

a discharge gate connected between said first node and said second node in the pixel group, and controlling a quantity of an exhaust current of said signal charge overflowing from said first node to said second node based on said control potential, wherein

said discharge gate is configured to increase said exhaust current as said control potential varies when the potential of said second node varies based on an accumulated quantity of said signal charge in said second node during said charge exhaust period.

**5.** The semiconductor image sensing device according to any one of claims 2 to 4, wherein said discharge gate is a variable resistance element varying its resistance value based on said control potential from said control potential generation unit, and said variable resistance element is configured such that said resistance value is decreased as said control potential varies in response to an increase of the accumulated quantity of said signal charge in said second node.

**6.** The semiconductor image sensing device according to any one of claims 2 to 4, wherein said discharge gate includes a first field effect transistor having a first impurity diffusion region constituting said first node as a source and a second impurity diffusion region constituting said second node as a drain, said control potential generation unit generates said control potential and outputs the control potential to said first field effect transistor so that a channel resistance between said source and said drain is decreased as the accumulated quantity of said signal charge in said second node is increased, said pixel circuit further includes:

a second field effect transistor configured to transfer said signal charge accumulated in said first impurity diffusion region to a third impurity diffusion region when said second field effect transistor is turned on in a saturated region or a linear region at said output timing, and

a second initialization circuit for clearing said signal charge in said third impurity diffusion region prior to turn-on of said second field effect transistor during single said frame period, and

said readout circuit is configured to output said electric signal corresponding to a quantity of said signal charge accumulated in said third impurity diffusion region at said output timing.

7.  The semiconductor image sensing device according to any one of claims 1 to 4, wherein
said accumulated charge exhaust circuit is formed in a region surrounded by said plurality of pixel circuits included in said corresponding pixel group, in a plane for receiving said incident light.

8.  The semiconductor image sensing device according to claim 1, wherein
said accumulated charge exhaust circuit does not executes said signal charge exhaust operation during said charge exhaust period when the incident light quantity to said corresponding pixel group is small.

9.  The semiconductor image sensing device according to claim 1, wherein
said accumulated charge exhaust circuit includes:

    a second node for receiving said signal charge exhausted from said first node when said signal charge exhaust operation is executed, and
    a discharge gate connected between said first node and said second node in said pixel group, and controlling a quantity of an exhaust current of said signal charge overflowing from said first node to said second node based on the incident light quantity to the corresponding pixel group during said charge exhaust period, and said discharge gate is configured to increase said exhaust current as the incident light quantity to said corresponding pixel group is increased.

10. The semiconductor image sensing device according to claim 9, wherein
said discharge gate is a variable resistance element varying its resistance value based on the incident light quantity to said corresponding pixel group, and
said variable resistance element is configured such that said resistance value is decreased as the incident light quantity to said corresponding pixel group is increase.

FIG. 1

FIG. 2

FIG. 3

FIG. 4

FIG. 5

(a)

PD

X ——————————————————————————————— X

SUB

INCIDENT LIGHT

PD

(b)

V

70

70

70

65

60

FIG. 6

(a)

PD

OFD

PD

X ——————————————————————————————— X

INCIDENT LIGHT

(b)

V

70

70

65

62

70

60

FIG. 7

FIG. 8

(a)

t0    70        70

W1  W2    W3    W4  W5

(b)

t1              70

W1  W2    W3    W4  W5

(c)

t2              70

W1  W2    W3    W4  W5

(d)

t3

W1  W2    W3    W4  W5

(e)

t4        70

W1  W2    W3    W4  W5

(f)

t5        70

W1  W2    W3    W4  W5

(g)

t6              70

W1  W2    W3    W4  W5

EP 2 023 613 A1

# FIG. 9

EP 2 023 613 A1

## FIG. 10

## FIG. 11

## FIG. 12

## FIG. 13

FIG. 14

VDD

5

PD

TO SIGNAL CHARGE
EXHAUST CIRCUIT
20# OR 21#

N1

12

Nf

16

PS

Vout

18

No

RF

14

6

VSS

10#

FIG. 15

VDD

5

PD

TO SIGNAL CHARGE
EXHAUST CIRCUIT
20# OR 21#

N1

16

PS

Vout

18

No

RF

14

6

VSS

11#

FIG. 16

FIG. 17

## INTERNATIONAL SEARCH REPORT

| | International application No. |
|---|---|
| | PCT/JP2007/059490 |

A. CLASSIFICATION OF SUBJECT MATTER
*H04N5/335*(2006.01)i, *H01L27/146*(2006.01)i

According to International Patent Classification (IPC) or to both national classification and IPC

B. FIELDS SEARCHED

Minimum documentation searched (classification system followed by classification symbols)
H04N5/335, H01L27/146

Documentation searched other than minimum documentation to the extent that such documents are included in the fields searched
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2005-109439 A (Seiko Epson Corp.), 21 April, 2005 (21.04.05), Par. Nos. [0074] to [0078] (Family: none) | 1-10 |
| A | JP 2000-340779 A (Mitsubishi Electric Corp.), 08 December, 2000 (08.12.00), Full text (Family: none) | 1-10 |
| A | JP 2005-160031 A (Sokichi HIROTSU), 16 June, 2005 (16.06.05), Full text & US 2005/117042 A1 & EP 1528597 A2 | 1-10 |

☒ Further documents are listed in the continuation of Box C. ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 07 August, 2007 (07.08.07) | 14 August, 2007 (14.08.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

| International application No. |
| --- |
| PCT/JP2007/059490 |

C (Continuation).   DOCUMENTS CONSIDERED TO BE RELEVANT

| Category* | Citation of document, with indication, where appropriate, of the relevant passages | Relevant to claim No. |
| --- | --- | --- |
| P,A | JP 2006-197383 A  (Canon Inc.),<br>27 July, 2006 (27.07.06),<br>Full text<br>& US 2006/158539 A1     & EP 1681850 A1 | 1-10 |

Form PCT/ISA/210 (continuation of second sheet) (April 2005)

**REFERENCES CITED IN THE DESCRIPTION**

**Patent documents cited in the description**

- JP 2000340779 A

- JP 2005160031 A